# EUROPEAN PATENT SPECIFICATION

(11) **EP 4 024 060 B1**
(45) Date of publication and mention of the grant of the patent: **04.12.2024**
(21) Application number: 20217696.2
(22) Date of filing: 29.12.2020
(51) Int. Cl.: G01R 31/12, G01R 31/34, H02K 3/28

(54) **GENERAL PURPOSE MODEL FOR HAIRPIN MACHINE INSULATION TESTING**
ALLZWECKMODELL FÜR ISOLATIONSPRÜFUNG VON HAARNADELMASCHINEN
MODÈLE À USAGE GÉNÉRAL POUR TEST D'ISOLATION DE MACHINE D'ÉPINGLE À CHEVEUX

(43) Date of publication of application: 06.07.2022
(73) Proprietor: ABB Schweiz AG, 5400 Baden (CH)
(72) Inventor: Sahlén, Fredrik, 723 49 Västerås (SE); Paulsson, Göran, 725 91 Västerås (SE)
(74) Representative: Kransell & Wennborg KB

(56) References cited:
- MANCINELLI P ET AL: "Lifetime analysis of an automotive electrical motor with hairpin wound stator", 2016 IEEE CONFERENCE ON ELECTRICAL INSULATION AND DIELECTRIC PHENOMENA (CEIDP), IEEE, 16 October 2016 (2016-10-16), pages 877 - 880, XP033026551, DOI: 10.1109/CEIDP.2016.7785538
- MANCINELLI PAOLO ET AL: "Qualification of Hairpin Motors Insulation for Automotive Applications", IEEE TRANSACTIONS ON INDUSTRY APPLICATIONS, IEEE SERVICE CENTER, PISCATAWAY, NJ, US, vol. 53, no. 3, 1 May 2017 (2017-05-01), pages 3110 - 3118, XP011650255, ISSN: 0093-9994, [retrieved on 20170518], DOI: 10.1109/TIA.2016.2619670
- KAMPKER ACHIM ET AL: "Inline Testing Method Based On Paschen's Law With Integrated Machine Learning For Hairpin Stator Production", 2020 10TH INTERNATIONAL ELECTRIC DRIVES PRODUCTION CONFERENCE (EDPC), IEEE, 8 December 2020 (2020-12-08), pages 1 - 8, XP033892781, DOI: 10.1109/EDPC51184.2020.9388208
- HE CHUXUAN ET AL: "Investigation of Partial Discharge Activity in the Slot of a Hairpin-wound Stator", 2020 INTERNATIONAL SYMPOSIUM ON ELECTRICAL INSULATING MATERIALS (ISEIM), TECHNICAL COMMITTEE ON DIELECTRICS & ELECTRICAL INSULATION, IEEJ, 13 September 2020 (2020-09-13), pages 565 - 568, XP033872536

## Description

### TECHNICAL FIELD

The present disclosure generally relates to general purpose models for insulation system testing of electrical machines.

### BACKGROUND

Electrical machines such as motors, may comprise a stator and a rotor. The stator has electrically insulated stator windings and a grounded stator frame which may comprise stator slots in which the stator windings are arranged. The stator slots may be provided with slot insulation.

Since the electrical insulation system in operation is subjected to heat due to the currents flowing through the windings, and external conditions such as vibrations and moisture, the electrical insulation system may eventually fail. Some faults that may occur are turn-to-turn faults, where the insulation between two adjacent winding turns fails, phase-to-ground faults, where the insulation of the winding fails towards ground, and phase-to-phase faults, where the insulation fails between two phases. All three cases can result in a short circuit and failure of the electrical machine. It is thus important to ensure that the electrical insulation system can withstand a certain number of operating hours before the risk of fault is substantially increased.

Extensive electrical testing is performed during electrical machine design, to ensure that the electrical insulation system can withstand the intended operating conditions of the electrical machine for certain hours of use. There are international standards for performing insulation tests for certain types of electrical machines. One such standard is IEC 60034-18-21 for rotating electrical machines with wire-wound windings.

Hairpin winding machines are electrical machines using a plurality of hairpin bars arranged in the stator slots, and which form the stator winding. There is currently no standardised way to perform thermal evaluation and classification of the insulation system of hairpin winding machines. One proposal is made by Mancinelli et al., in the paper "Qualification of hairpin motors insulation for automotive applications", published in IEEE Transactions on Industrial Applications, pp. 3110-3118, on 20 October 2016. The document discloses the use of a quarter of a Syrnemo motor stator with as a formettefor testing the phase-to-phase and phase-to-ground insulation. Moreover, coupled bars are used for testing the turn-to-turn insulation. Samples are subjected to vibrations, heat inside an oven, and to voltage tests.

The paper "Lifetime analysis of an automotive electrical motor with hairpin wound stator" by Mancinelli P. et al, 2016 IEEE Conference on electrical insulation and dielectric phenomena, IEEE, 16 October 2016, pages 877-880, discloses the use of formettes shaped as a quarter of a SyrNemo motor stator, with bars kept in their slots and covered by polyiamide slot liner. Coupled bars are used to evaluate the turn-to-turn insulation.

The paper "Inline testing method based on Paschen's law with integrated machine learning for hairpin stator production" by Kampker A. et al, 2020 10th International electric drives production conference, IEEE, 8 December 2020, pages 1-8, discloses that pre-tests of a testing method based on Paschen's law have shown that insulation faults can be detected by an optical-electrical test. In combination with a Machine Learning concept, the causes of the insulation damage can be quickly identified and assigned to the upstream process step.

The paper "Investigation of partial discharge activity in the slot of a hairpin-wound stator", 2020 International symposium on electrical insulating materials, Technical committee on dielectrics & electrical insulation, IEEJ, 13 September 2020, pages 565-568, discloses investigation of partial discharge phenomena in the turns of a hairpin wound stator by a miniaturized test block representing a single slot of the stator, in which multiple conductors can be placed.

### SUMMARY

One drawback with the test models employed is that the Syrnemo motor stator model is relatively complex. Moreover, the testing requires two types of models for performing e.g. turn-to-turn insulation tests and phase-to-phase tests.

An object of the present disclosure is to provide a general purpose model which solves, or at least mitigates problems of the prior art.

There is hence according to a first aspect of the present disclosure provided a general purpose model for thermal evaluation and classification of the electrical insulation system of an electric machine with hairpin windings, the general purpose model comprising: a stator frame model provided with a first stator slot and a second stator slot arranged adjacent to each other, wherein each of the first stator slot and the second stator slot has a slot insulation, and a first hairpin bar and a second hairpin bar, each hairpin bar having a first leg, a second leg, and a hairpin bend extending between the first leg and the second leg, wherein the hairpin bars are stacked on each other with the first legs being arranged in the first stator slot and the second legs being arranged in the second stator slot, wherein the first leg and the second leg comprise a conductor insulation, and end portions of the first leg and the second leg are without conductor insulation.

A simple general purpose model may thereby be provided, which enables turn-to-turn, phase-to-ground, and phase-to-phase insulation system testing in a single device. The electrical insulation system of an electrical machine with hairpin windings, such as an electric motor for electric vehicles, may thereby be tested and evaluated.

The slot insulation material and thickness, and the conductor insulation material and thickness should correspond to those of the electrical insulation system of the electrical machine under evaluation.

The hairpin bars are made of an electrically conductive material such as copper or aluminium.

The conductor insulation may for example comprise enamel.

According to one embodiment the first stator slot and the second stator slot are provided on an otherwise flat or essentially flat surface of the stator frame model. The surface of the stator frame model provided with the first stator slot and the second stator slot may thus be planar or essentially planar.

The first stator slot and the second stator slot may be arranged parallel with each other.

The first stator slot and the second stator slot may be provided in the same plane parallel with said flat or essentially flat surface.

The stator frame model may have a cuboid shape. It is thus simple to manufacture the stator frame model.

The stator frame model may for example be made of aluminium, stainless steel, or copper.

According to one embodiment the stator frame model has exactly two stator slots. The stator frame model may thus have no more and no less than two stator slots.

According to one embodiment all the hairpin bars are two-dimensional hairpin bars. Two-dimensional hairpin bars extend in one plane. This simplifies the construction because no further processing such as bending of the hairpin bars is required once they have been formed with two legs and a hairpin bend. It furthermore simplifies the mounting of the hairpin bars in the first and second stator slots.

Three-dimensional hairpin bars have legs that extend in two parallel planes offset from each other. The hairpin bend may be bent in three dimensions instead of two.

All the hairpin bars may according to one example be three-dimensional hairpin bars.

According to one embodiment adjacent hairpin bars are arranged with the hairpin bends in opposite directions. This simplifies connection of the end portions without conductor insulation to a power source or to ground. It furthermore moves a ground connector or clamp connected to an end portion of one hairpin bar further away from a phase connector or clamp connected to an end portion of another hairpin bar.

One embodiment comprises a third hairpin bar having a first leg, a second leg and a hairpin bend extending between the first leg and the second leg, wherein the third hairpin bar has its first leg arranged in the first stator slot and its second leg arranged in the second stator slot, wherein the third hairpin bar is arranged adjacent to the second hairpin bar, and wherein the general purpose model comprises a phase insulation arranged between the third hairpin bar and the second hairpin bar.

Three hairpin bars allow also for phase-to-phase testing in the same test setup, testing the phase insulation, in addition to turn-to-turn and phase-to-ground testing.

The phase insulation may extend between the third hairpin bar and the second hairpin bar along at least the entire axial length of the first stator slot and the second stator slot.

According to one embodiment the stator frame model and all the hairpin bars are coated with a cured impregnation resin. The cured impregnation resin holds together the general purpose model to reduce the wear on the conductor insulation during for example mechanical stress tests.

One embodiment comprises at most four hairpin bars.

According to one embodiment the stator frame model is made of solid metal. This simplifies manufacturing of the stator frame model, compared to laminated structures.

One embodiment comprises a fastener which fastens the hairpin bars to the stator frame model. The fastener may for example comprise one or two metal bars placed over the stator slots when all the hairpin bars are arranged in the two stator slots. The metal bars may be attached to the stator frame model by screws to fixate the hairpin bars to the stator frame model.

There is according to a second aspect of the present disclosure provided a method of performing thermal evaluation and classification of the electrical insulation system of an electric machine with hairpin windings using a general purpose model according to the first aspect, the method comprising: performing at least one of a turn-to-turn insulation test, a phase-to-ground insulation test and a phase-to-phase insulation test.

According to one embodiment comprises the turn-to-turn insulation test comprises: connecting one of the first and the second leg of the first hairpin bar to a power source, connecting one of the first and second leg of the second hairpin bar arranged adjacent to the first hairpin bar to ground, and applying a voltage to the first hairpin bar.

According to one embodiment the phase-to-ground insulation test comprises: connecting one of the first and the second leg of the first hairpin bar to a power source, connecting the stator frame model to ground, and applying a voltage to the first hairpin bar.

One embodiment comprises: connecting one of the first and the second leg of the second hairpin bar to the power source, and applying a voltage to the second hairpin bar. The voltages may be applied simultaneously to the first hairpin bar and the second hairpin bar. The voltage applied to the first hairpin bar and the second hairpin bar may be the same voltage.

According to one embodiment the phase-to-phase insulation test comprises: connecting one of the first and the second leg of the second hairpin bar to the power source, connecting one of the first and second leg of the third hairpin bar to ground, and applying a voltage to the second hairpin bar while the stator frame model is floating.

The three insulation tests may be performed according to any order.

Generally, all terms used in the claims are to be interpreted according to their ordinary meaning in the technical field, unless explicitly defined otherwise herein. All references to "a/an/the element, apparatus, component, means, etc." are to be interpreted openly as referring to at least one instance of the element, apparatus, component, means, etc., unless explicitly stated otherwise.

### BRIEF DESCRIPTION OF THE DRAWINGS

The specific embodiments of the inventive concept will now be described, by way of example, with reference to the accompanying drawings, in which:
Fig. 1 schematically shows a perspective view of an example of a stator frame model and a hairpin bar of a general purpose model for thermal evaluation and classification of the electrical insulation system of an electric machine with hairpin windings;
Fig. 2 shows a top view of a general purpose model;
Fig. 3 schematically depicts a top view of a general purpose model during a turn-to-turn insulation test;
Fig. 4 schematically depicts a top view of a general purpose model during a phase-to-ground insulation test; and
Fig. 5 schematically shows a section along one of the stator slots during a phase-to-phase insulation test.

### DETAILED DESCRIPTION

The inventive concept will now be described more fully hereinafter with reference to the accompanying drawings, in which exemplifying embodiments are shown. The inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description.

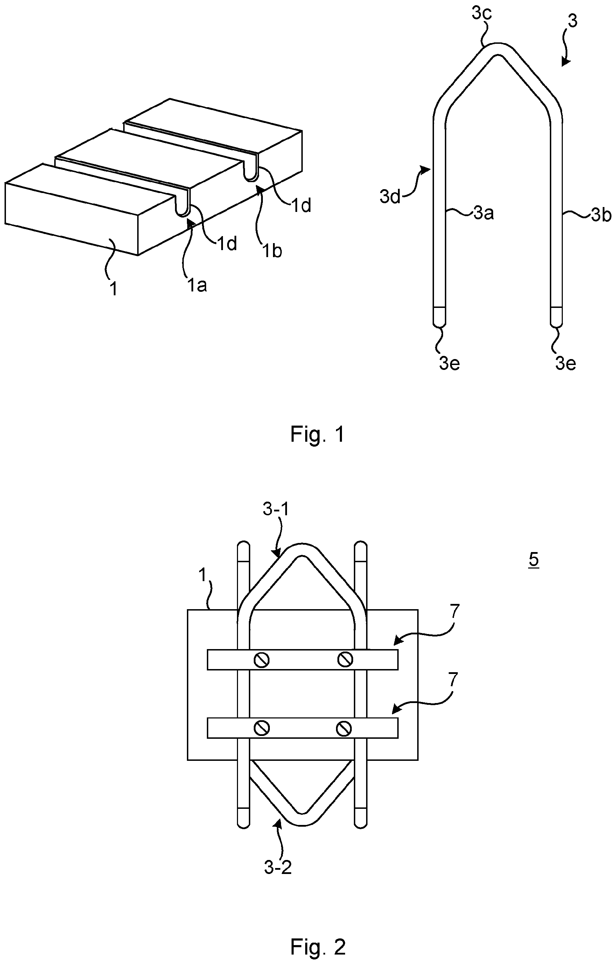

Fig. 1 shows an example of a stator frame model 1 and a hairpin bar 3 for a general purpose model for thermal evaluation and classification of the electrical insulation system of an electric machine with hairpin windings.

The stator frame model 1 may have a cuboid shape. The stator frame model 1 may be a block made of metal. The stator frame model 1 may be made of a single piece of metal. The metal may for example be aluminium, steel or copper. The stator frame model 1 may be solid.

The stator frame model 1 comprises a first stator slot 1a and a second stator slot 1b. The stator frame model 1 may have a surface which is flat or essentially flat, and in which the first stator slot 1a and the second stator slot 1b are provided.

The first stator slot 1a and the second stator slot 1b are arranged parallel with each other. The first stator slot 1a is arranged adjacent to the second stator slot 1b. There are thus no other stator slots provided between the first stator slot 1a and the second stator slot 1b. Preferably, the stator frame model 1 comprises only two stator slots, i.e. the first stator slot 1a and the second stator slot 1b.

The stator frame model 1 comprises slot insulation 1d. Each of the first stator slot 1a and the second stator slot 1b is provided with a slot insulation 1d. The slot insulation 1d is thus arranged in the first stator slot 1a and in the second stator slot 1b.

The thickness and material of the slot insulation 1d may depend on the particular design to be evaluated. The slot insulation 1d may for example be polymer-based, such as biopolymer-based e.g. cellulose-based, and/or synthetic polymer-based.

The hairpin bar 3 is made of metal. The metal may for example be copper or aluminium. The hairpin bar 3 has a first leg 3a and a second leg 3b. The hairpin bar 3 has a hairpin bend 3c which extends between the first leg 3a and the second leg 3b. The hairpin bend 3c connects the first leg 3a with the second leg 3b.

The hairpin bar 3 has a conductor insulation 3d. The conductor insulation 3d is an insulation layer provided on the electrically conducting metal material of the hairpin bar 3. The thickness and the material conductor insulation 3d may depend on the particular design to be evaluated. The conductor insulation 3d may for example comprise or consist of enamel.

Each of the first leg 3a and the second leg 3b has an end portion 3e which is without conductor insulation 3d. The underlying metal of the hairpin bar 3 is thus exposed at the end portions 3e. In other words, the end portions 3e are free from conductor insulation 3d. This simplifies connection to a power source and/or to ground, which can be performed by means of clamps for example.

The hairpin bar 3 is configured to be arranged with its first leg 3a in the first stator slot 1a and the second leg 3b in the second stator slot 1b or vice versa.

Fig. 2 shows a top view of an example of a general purpose model 5. The general purpose model 5 comprises the stator frame model 1 and may for example comprise any number between two and four hairpin bars 3 arranged stacked on each other with their first leg in the first stator slot 1a and their second leg in the second stator slot 1b.

In the example, adjacent hairpin bars 3 are arranged with the hairpin bends 3c in opposite directions. The orientation of the hairpin bends 3c is thus arranged alternatingly in the stack. This can be seen by the orientation of two hairpin bars of the type described in Fig. 1, here denoted a first hairpin bar 3-1 and a second hairpin bar 3-2.

The general purpose model 5 may comprise fasteners 7 configured to hold the hairpin bars 3, 3-1, 3-2 in the first stator slot 1a and the second stator slot 1b. The fasteners 7 may for example be in the form of bars, such as metal bars, extending across the first stator slot 1a and the second stator slot 1b, and which are attached to the stator frame model 1 by means of e.g. screws or bolts.

The stator frame model 1 and the hairpin bars 3, 3-1, 3-2 may be coated with an impregnation resin that has been cured. The impregnation of the hairpin bars 3, 3-1, 3-2 with the impregnation resin may for example take place before the conductor insulation 3d is removed from the end portions 3e of the first leg 3a and the second leg 3b to expose the underlying metal.

The general purpose model 5 is designed for testing the slot insulation 1d, the conductor insulation 3d, the impregnation resin, and in some examples a phase insulation, which correspond to the components of the electrical insulation system of the stator of a hairpin electrical machine.

The test procedure may involve using a plurality of the general purpose models 5, for example 30-40 general purpose models 5 to obtain a statistical basis when evaluating and classifying the electrical insulation system.

The test procedure may comprise none, or one or more of the following test stages before the voltage tests which will be descried hereinafter.

A plurality of general purpose models 5 may for example be arranged in racks during the first optional stages of testing. Each rack may for example comprise at least 5, such as 10, general purpose models 5.

In a first stage of testing, the general purpose models 5 of each rack may be subjected to thermal stress. Each rack may for example be placed in a heating chamber, such as an oven, and subjected to a predetermined temperature for a predetermined amount of time. Heating could alternatively be performed by other methods such as direct heating by electric current. The general purpose models 5 of each rack is subjected to a different temperature during the thermal stress test. Three different racks may for example be used, each heated at a different temperature.

In the next stage of testing, the general purpose models may be subjected to mechanical stress in the form of vibrations with a certain amplitude and frequency for a predetermined amount of time. A shaker may be used for this purpose.

Next, the general purpose models 5 may be exposed to moisture in a climate chamber for a predetermined amount of time.

The general purpose models 5 may then be subjected to voltage tests while they are still moist. The process with all or some of the aforementioned stages is then repeated for each set of general purpose models 5 until the insulation system begins to fail. Examples of voltage tests will be described in the following. The voltage tests are preferably performed using alternating current with e.g. a frequency in the range of 40-70 Hz.

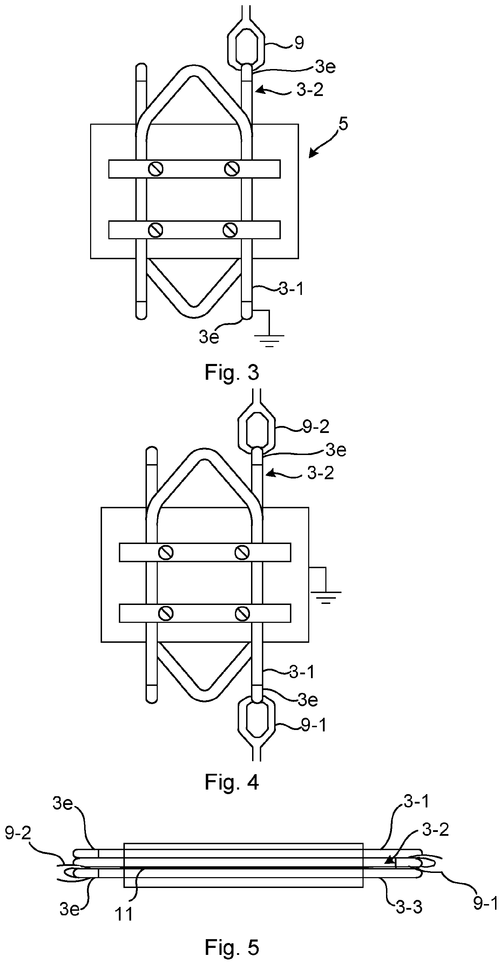

Fig. 3 shows an example of a turn-to-turn insulation test of the general purpose model 5. One of the legs, in particular an end portion 3e thereof, of a first hairpin bar 3-1 is connected to ground. The end portion 3e of one leg of a second hairpin bar 3-2 arranged adjacent to the first hairpin bar 3-1 is connected to a power source. In the example, a clamp 9 which is electrically connected to the power source is connected to the end portion 3e of the second hairpin bar 3-2. A voltage is then applied to the second hairpin bar 3-2 for a predetermined amount of time. The stator frame model 1 may be grounded or floating.

Fig. 4 shows an example of a phase-to-ground insulation test of the general purpose model 5. The stator frame model 1 is in this case grounded. One of the legs, in particular an end portion 3e thereof, of the first hairpin bar 3-1 is connected to the power source. In the example, a first clamp 9-1, which is electrically connected to the power source, is connected to the end portion 3e of the first hairpin bar 3-1.

The end portion 3e of one leg of the second hairpin bar 3-2 arranged adjacent to the first hairpin bar 3-1 may also be connected to the power source by means of a second clamp 9-2. Alternatively, the first hairpin bar 3-1 and the second hairpin bar 3-2 may be short-circuited by connecting the end portion of one of the hairpin bars to the end portion of the other one of the hairpin bars.

A voltage is then applied to the first hairpin bar 3-1 for a predetermined amount of time. A voltage may also be applied to the second hairpin bar 3-2 for the predetermined amount of time if it is connected to the power source by means of the second clamp 9-2.

The applied voltage may be higher in the phase-to-ground insulation test than in the turn-to-turn insulation test.

According to one variation, at least the lowermost hairpin bar of the hairpin bars arranged in the two stator slots 1a, 1b may be connected to the power source during the phase-to-ground insulation test.

Fig. 5 shows an example of a phase-to-phase insulation test of the general purpose model 5. In this example three hairpin bars 3-1 to 3-3 are arranged stacked in the first stator slot 1a and the second stator slot 1b. The second hairpin bar 3-2 is arranged between the first hairpin bar 3-1 and the third hairpin bar 3-3. A phase insulation 11 is arranged between the second hairpin bar 3-2 and the third hairpin bar 3-3. One of the legs, in particular an end portion 3e thereof, of the second hairpin bar 3-2 is connected to the power source. In the example, the first clamp 9-1 which is electrically connected to the power source is connected to the end portion 3e of the second hairpin bar 3-2. The end portion 3e of one leg of the third hairpin bar 3-3 is connected to ground means of the second clamp 9-2. The stator frame model 1 is in this case floating. The applied voltage may be higher in the phase-to-phase insulation test than in the turn-to-turn insulation test.

Based on the tests, the electrical insulation system may be evaluated and classified using methods such as those described in e.g. IEC-60034-18-21.

The inventive concept has mainly been described above with reference to a few examples. However, as is readily appreciated by a person skilled in the art, other embodiments than the ones disclosed above are equally possible within the scope of the inventive concept, as defined by the appended claims.

## Claims

1. A general purpose model (5) for thermal evaluation and classification of the electrical insulation system of an electric machine with hairpin windings, the general purpose model (5) comprising:
a stator frame model (1) provided with a first stator slot (1a) and a second stator slot (1b) arranged adjacent to each other, wherein each of the first stator slot (1a) and the second stator slot (1b) has a slot insulation (1d), and
a first hairpin bar (3, 3-1) and a second hairpin bar (3, 3-2), each hairpin bar (3-1, 3-2) having a first leg (3a), a second leg (3b), and a hairpin bend (3c) extending between the first leg (3a) and the second leg (3b),
wherein the first leg (3a) and the second leg (3b) comprise a conductor insulation (3d), and end portions (3e) of the first leg (3a) and the second leg (3b) are without conductor insulation (3d);
**characterised in that**
the hairpin bars (3, 3-1, 3-2) are stacked on each other with the first legs (3a) being arranged in the first stator slot (1a) and the second legs (3b) being arranged in the second stator slot (1b).

2. The general purpose model (5) as claimed in claim 1, wherein the first stator slot (1a) and the second stator slot (1b) are provided on an otherwise flat or essentially flat surface of the stator frame model (1).

3. The general purpose model (5) as claimed in claim 1 or 2, wherein the stator frame model (1) has exactly two stator slots (1a, 1b).

4. The general purpose model (5) as claimed in any of the preceding claims, wherein all the hairpin bars (3, 3-1, 3-2) are two-dimensional hairpin bars.

5. The general purpose model (5) as claimed in any of the preceding claims, wherein adjacent hairpin bars (3, 3-1, 3-2, 3-3) are arranged with the hairpin bends (3c) in opposite directions.

6. The general purpose model (5) as claimed in any of the preceding claims, comprising a third hairpin bar (3-3) having a first leg, a second leg and a hairpin bend extending between the first leg and the second leg, wherein the third hairpin bar has its first leg arranged in the first stator slot (1a) and its second leg arranged in the second stator slot (1b, wherein the third hairpin bar (3-1) is arranged adjacent to the second hairpin bar (3-2), and wherein the general purpose model (5) comprises a phase insulation (11) arranged between the third hairpin bar (3-3) and the second hairpin bar (3-2).

7. The general purpose model (5) as claimed in any of the preceding claims, wherein the stator frame model (1) and all the hairpin bars (3, 3-1, 3-2, 3-3) are coated with a cured impregnation resin.

8. The general purpose model (5) as claimed in any of the preceding claims, comprising at most four hairpin bars (3).

9. The general purpose model (5) as claimed in any of the preceding claims, wherein the stator frame model (1) is made of solid metal.

10. The general purpose model (5) as claimed in any of the preceding claims, comprising a fastener (7) which fastens the hairpin bars (3, 3-1, 3-2, 3-3) to the stator frame model (1).

11. A method of performing thermal evaluation and classification of the electrical insulation system of an electric machine with hairpin windings using a general purpose model (5) as claimed in any of the preceding claims, the method comprising: performing at least one of a turn-to-turn insulation test, a phase-to-ground insulation test and a phase-to-phase insulation test.

12. The method as claimed in claim 11, wherein the turn-to-turn insulation test comprises:
- connecting one of the first and the second leg (3a, 3b) of the first hairpin bar (3-1) to a power source,
- connecting one of the first and second leg (3a, 3b) of the second hairpin bar (3-2) arranged adjacent to the first hairpin bar (3-1) to ground, and
- applying a voltage to the first hairpin bar (3-1).

13. The method as claimed in claim 11 or 12, wherein the phase-to-ground insulation test comprises:
- connecting one of the first and the second leg (3a, 3b) of the first hairpin bar (3-1) to a power source,
- connecting the stator frame model (1) to ground, and
- applying a voltage to the first hairpin bar (3-1).

14. The method as claimed in claim 13, comprising:
- connecting one of the first and the second leg (3a, 3b) of the second hairpin bar (3-2) to the power source, and
- applying a voltage to the second hairpin bar (3-2).

15. The method as claimed in any of claims 11-14 dependent on claim 6, wherein the phase-to-phase insulation test comprises:
- connecting one of the first and the second leg (3a, 3b) of the second hairpin bar (3-2) to the power source,
- connecting one of the first and second leg (3a, 3b) of the third hairpin bar (3-3) to ground, and
applying a voltage to the second hairpin bar (3-2) while the stator frame model (1) is floating.

## Patentansprüche

1. Allzweckmodell (5) für eine thermische Bewertung und Klassifizierung des elektrischen Isoliersystems einer elektrischen Maschine mit Haarnadelwindungen, wobei das Allzweckmodell (5) Folgendes umfasst:
ein Statorgehäusemodell (1), das mit einem ersten Statorschlitz (1a) und einem zweiten Statorschlitz (1b), die aneinander angrenzend angeordnet sind, versehen ist, wobei der erste Statorschlitz (1a) und der zweite Statorschlitz (1b) jeweils eine Schlitzisolierung (1d) aufweisen, und
einen ersten Haarnadeldraht (3, 3-1) und einen zweiten Haarnadeldraht (3, 3-2), wobei jeder Haarnadeldraht (3-1, 3-2) einen ersten Schenkel (3a), einen zweiten Schenkel (3b) und eine sich zwischen dem ersten Schenkel (3a) und dem zweiten Schenkel (3b) erstreckende Haarnadelkrümmung (3c) aufweist,
wobei der erste Schenkel (3a) und der zweite Schenkel (3b) eine Leiterisolierung (3d) umfassen und die Endabschnitte (3e) des ersten Schenkels (3a) und des zweiten Schenkels (3b) ohne Leiterisolierung (3d) sind;
**dadurch gekennzeichnet, dass**
die Haarnadeldrähte (3, 3-1, 3-2) aufeinander gestapelt sind, wobei die ersten Schenkel (3a) im ersten Statorschlitz (1a) angeordnet sind und die zweiten Schenkel (3b) im zweiten Statorschlitz (1b) angeordnet sind.

2. Allzweckmodell (5) nach Anspruch 1, wobei der erste Statorschlitz (1a) und der zweite Statorschlitz (1b) auf einer andernfalls planen oder im Wesentlichen planen Fläche des Statorgehäusemodells (1) vorgesehen sind.

3. Allzweckmodell (5) nach Anspruch 1 oder 2, wobei das Statorgehäusemodell (1) genau zwei Statorschlitze (1a, 1b) aufweist.

4. Allzweckmodell (5) nach einem der vorstehenden Ansprüche, wobei alle Haarnadeldrähte (3, 3-1, 3-2) zweidimensionale Haarnadeldrähte sind.

5. Allzweckmodell (5) nach einem der vorstehenden Ansprüche, wobei angrenzende Haarnadeldrähte (3, 3-1, 3-2, 3-3) mit den Haarnadelkrümmungen (3c) in entgegengesetzte Richtungen angeordnet sind.

6. Allzweckmodell (5) nach einem der vorstehenden Ansprüche, umfassend einen dritten Haarnadeldraht (3-3) mit einem ersten Schenkel, einem zweiten Schenkel und einer sich zwischen dem ersten Schenkel und dem zweiten Schenkel erstreckenden Haarnadelkrümmung, wobei der dritte Haarnadeldraht einen ersten Schenkel aufweist, der im ersten Statorschlitz (1a) angeordnet ist, und einen zweiten Schenkel, der im zweiten Statorschlitz (1b) angeordnet ist, wobei der dritte Haarnadeldraht (3-1) an den zweiten Haarnadeldraht (3-2) angrenzend angeordnet ist und wobei das Allzweckmodell (5) eine Phasenisolierung (11) umfasst, die zwischen dem dritten Haarnadeldraht (3-3) und dem zweiten Haarnadeldraht (3-2) angeordnet ist.

7. Allzweckmodell (5) nach einem der vorstehenden Ansprüche, wobei das Statorgehäusemodell (1) und alle Haarnadeldrähte (3, 3-1, 3-2, 3-3) mit einem ausgehärteten Imprägnierharz beschichtet sind.

8. Allzweckmodell (5) nach einem der vorstehenden Ansprüche, höchstens vier Haarnadeldrähte (3) umfassend.

9. Allzweckmodell (5) nach einem der vorstehenden Ansprüche, wobei das Statorgehäusemodell (1) aus massivem Metall gefertigt ist.

10. Allzweckmodell (5) nach einem der vorstehenden Ansprüche, umfassend ein Befestigungselement (7), das die Haarnadeldrähte (3, 3-1, 3-2, 3-3) am Statorgehäusemodell (1) befestigt.

11. Verfahren zum Durchführen einer thermischen Bewertung und Klassifizierung des elektrischen Isoliersystems einer elektrischen Maschine mit Haarnadelwindungen unter Verwendung eines Allzweckmodells (5) nach einem der vorstehenden Ansprüche, wobei das Verfahren Folgendes umfasst: Durchführen mindestens eines Windung-Windung-Isoliertests, eines Phase-Erdung-Isoliertests und eines Phase-Phase-Isoliertests.

12. Verfahren nach Anspruch 11, wobei der Windung-Windung-Isoliertest Folgendes umfasst:
- Verbinden des ersten oder zweiten Schenkels (3a, 3b) des ersten Haarnadeldrahts (3-1) mit einer Stromquelle,
- Verbinden des ersten oder zweiten Schenkels (3a, 3b) des an den ersten Haarnadeldraht (3-1) angrenzend angeordneten zweiten Haarnadeldrahts (3-2) mit der Erdung und
- Aufbringen einer Spannung auf den ersten Haarnadeldraht (3-1).

13. Verfahren nach Anspruch 11 oder 12, wobei der Windung-Erdung-Isoliertest Folgendes umfasst:
- Verbinden des ersten oder zweiten Schenkels (3a, 3b) des ersten Haarnadeldrahts (3-1) mit einer Stromquelle,
- Verbinden des Statorgehäusemodells (1) mit der Erdung und
- Aufbringen einer Spannung auf den ersten Haarnadeldraht (3-1).

14. Verfahren nach Anspruch 13, Folgendes umfassend:
- Verbinden des ersten oder zweiten Schenkels (3a, 3b) des zweiten Haarnadeldrahts (3-2) mit der Stromquelle und
- Aufbringen einer Spannung auf den zweiten Haarnadeldraht (3-2).

15. Verfahren nach einem der Ansprüche 11-14, wenn abhängig von Anspruch 6, wobei der Phase-Phase-Isoliertest Folgendes umfasst:
- Verbinden des ersten oder zweiten Schenkels (3a, 3b) des zweiten Haarnadeldrahts (3-2) mit der Stromquelle,
- Verbinden des ersten oder zweiten Schenkels (3a, 3b) des dritten Haarnadeldrahts (3-3) mit der Erdung und
- Aufbringen einer Spannung auf den zweiten Haarnadeldraht (3-2), während das Statorgehäusemodell (1) nicht geerdet ist.

## Revendications

1. Modèle à usage général (5) pour l'évaluation thermique et la classification du système d'isolation électrique d'une machine électrique à enroulements en épingle à cheveux, le modèle à usage général (5) comprenant :
un modèle de cadre de stator (1) doté d'une première fente de stator (1a) et d'une deuxième fente de stator (1b) agencées côte à côte, chacune de la première fente de stator (1a) et de la deuxième fente de stator (1b) étant dotée d'une isolation de fente (1d), et
une première barrette en épingle à cheveux (3, 3-1) et une deuxième barrette en épingle à cheveux (3, 3-2), chaque barrette en épingle à cheveux (3-1, 3-2) ayant une première jambe (3a), une deuxième jambe (3b), et un coude d'épingle à cheveux (3c) s'étendant entre la première jambe (3a) et la deuxième jambe (3b),
dans lequel la première jambe (3a) et la deuxième jambe (3b) comprennent une isolation de conducteur (3d), et les parties d'extrémité (3e) de la première jambe (3a) et de la deuxième jambe (3b) sont dépourvues d'isolation de conducteur (3d) ;
**caractérisé en ce que**
les barrettes en épingle à cheveux (3, 3-1, 3-2) sont empilées les unes sur les autres, les premières jambes (3a) étant disposées dans la première fente de stator (1a) et les deuxièmes jambes (3b) étant disposées dans la deuxième fente de stator (1b).

2. Modèle à usage général (5) selon la revendication 1, dans lequel la première fente de stator (1a) et la deuxième fente de stator (1b) sont disposées sur une surface par ailleurs plane ou sensiblement plane du modèle de cadre de stator (1).

3. Modèle à usage général (5) selon la revendication 1 ou 2, dans lequel le modèle de cadre de stator (1) comporte exactement deux fentes de stator (1a, 1b).

4. Modèle à usage général (5) selon l'une quelconque des revendications précédentes, dans lequel toutes les barrettes en épingle à cheveux (3, 3-1, 3-2) sont des barrettes en épingle à cheveux bidimensionnelles.

5. Modèle à usage général (5) selon l'une quelconque des revendications précédentes, dans lequel les barrettes en épingle à cheveux adjacentes (3, 3-1, 3-2, 3-3) sont agencées de manière à ce que les coudes d'épingle à cheveux (3c) soient dans des directions opposées.

6. Modèle à usage général (5) selon l'une quelconque des revendications précédentes, comprenant une troisième barrette en épingle à cheveux (3-3) ayant une première jambe, une deuxième jambe et un coude d'épingle à cheveux s'étendant entre la première jambe et la deuxième jambe, la première jambe de la troisième barrette en épingle à cheveux étant agencée dans la première fente de stator (1a) et sa deuxième jambe étant agencée dans la deuxième fente de stator (1b), la troisième barrette en épingle à cheveux (3-1) étant agencée de manière adjacente à la deuxième barrette en épingle à cheveux (3-2), et le modèle à usage général (5) comprenant une isolation de phase (11) agencée entre la troisième barrette en épingle à cheveux (3-3) et la deuxième barrette en épingle à cheveux (3-2).

7. Modèle à usage général (5) selon l'une quelconque des revendications précédentes, dans lequel le modèle de cadre de stator (1) et toutes les barrettes en épingle à cheveux (3, 3-1, 3-2, 3-3) sont revêtus d'une résine d'imprégnation durcie.

8. Modèle à usage général (5) selon l'une quelconque des revendications précédentes, comprenant au plus quatre barrettes en épingle à cheveux (3).

9. Modèle à usage général (5) selon l'une quelconque des revendications précédentes, dans lequel le modèle de cadre de stator (1) est constitué d'un métal plein.

10. Modèle à usage général (5) selon l'une quelconque des revendications précédentes, comprenant un élément de fixation (7) qui fixe les barrettes en épingle à cheveux (3, 3-1, 3-2, 3-3) au modèle de cadre de stator (1).

11. Procédé pour réaliser l'évaluation thermique et la classification du système d'isolation électrique d'une machine électrique à enroulements en épingle à cheveux à l'aide d'un modèle à usage général (5) selon l'une quelconque des revendications précédentes, le procédé comprenant : la réalisation d'au moins un test d'isolation de spire à spire, un test d'isolation de phase à terre et un test d'isolation de phase à phase.

12. Procédé selon la revendication 11, dans lequel le test d'isolation de spire à spire comprend :
- la connexion de l'une de la première et de la deuxième jambe (3a, 3b) de la première barrette en épingle à cheveux (3-1) à une source d'alimentation,
- la connexion de l'une de la première et de la deuxième jambe (3a, 3b) de la deuxième barrette en épingle à cheveux (3-2) agencée de manière adjacente à la première barrette en épingle à cheveux (3-1) à la terre, et
- l'application d'une tension à la première barrette en épingle à cheveux (3-1).

13. Procédé selon la revendication 11 ou 12, dans lequel le test d'isolation de spire à terre comprend :
- la connexion de l'une de la première et de la deuxième jambe (3a, 3b) de la première barrette en épingle à cheveux (3-1) à une source d'alimentation,
- la connexion du modèle de cadre de stator (1) à la terre, et
- l'application d'une tension à la première barrette en épingle à cheveux (3-1).

14. Procédé selon la revendication 13, comprenant :
- la connexion de l'une de la première et de la deuxième jambe (3a, 3b) de la deuxième barrette en épingle à cheveux (3-2) à la source d'alimentation, et
- l'application d'une tension à la deuxième barrette en épingle à cheveux (3-2).

15. Procédé selon l'une quelconque des revendications 11-14 lorsqu'elles dépendent de la revendication 6, dans lequel le test d'isolation de phase à phase comprend :
- la connexion de l'une de la première et de la deuxième jambe (3a, 3b) de la deuxième barrette en épingle à cheveux (3-2) à la source d'alimentation,
- la connexion de l'une de la première et de la deuxième jambe (3a, 3b) de la troisième barrette en épingle à cheveux (3-3) à la terre, et
- l'application d'une tension à la deuxième barrette en épingle à cheveux (3-2) tandis que le modèle de cadre de stator (1) est flottant.
